# FASCICULE DE BREVET EUROPEEN

(11) **EP 3 544 056 B1**
(45) Date de publication et mention de la délivrance du brevet: **12.02.2025**
(21) Numéro de dépôt: 19162360.2
(22) Date de dépôt: 12.03.2019
(51) Int. Cl.: H01L 27/02, H01L 29/861

(54) **CIRCUIT DE PROTECTION ESD ET SON PROCÉDÉ DE FABRICATION**
ESD-SCHUTZSCHALTKREIS UND SEIN HERSTELLUNGSVERFAHREN
ESD PROTECTION CIRCUIT AND METHOD FOR MANUFACTURING SAME

(30) Priorité: 21.03.2018 FR 1852428
(43) Date de publication de la demande: 25.09.2019
(73) Titulaire: STMicroelectronics S.r.l., 20864 Agrate Brianza (MB) (IT); STMicroelectronics (Tours) SAS, 37100 Tours (FR)
(72) Inventeur: ARNAUD, Aurélie, 37540 Saint-Cyr-sur-Loire (FR); BRISCHETTO, Andrea, 95122 Catania (IT)
(74) Mandataire: Cabinet Beaumont

(56) Documents cités:
- EP-A1- 2 741 330
- US-A1- 2011 163 352
- US-A1- 2013 075 747
- US-A1- 2014 319 598
- US-A1- 2018 047 718

## Description

### Domaine

La présente description concerne des circuits de protection contre les décharges électrostatiques et leurs procédés de fabrication.

### Exposé de l'art antérieur

Les problématiques liées aux décharges électrostatiques sont d'autant plus présentes aujourd'hui que les composants dans les circuits électroniques sont de plus en plus petits et de plus en plus proches les uns des autres. La protection des circuits électroniques contre les décharges électrostatiques est un enjeu important pour assurer la fiabilité et la longévité de ces circuits.

Il existe donc un besoin permanent pour des circuits de protection contre les décharges électrostatiques plus performants. Plus précisément, il existe un besoin permanent d'améliorer la qualité de protection pour satisfaire aux demandes croissantes en termes de performances des applications haut débit.

Le document US 2014/0319598 décrit des configurations optimisées pour intégrer des diodes directrices dans des suppresseurs de tensions transitoires à faible capacité

Le document EP 2 741 330 décrit un circuit de protection ESD.

Le document US 2013/0075747 décrit un circuit de protection ESD utilisant des diodes Zener à faible fuite formées par des radiations microondes.

Le document US 2011/0163352 décrit un dispositif de protection ESD monolithique multicanaux.

Le document US 2018/00477718 décrit une structure semiconductrice de dispositif de protection ESD et son procédé de fabrication.

### Résumé

L'invention concerne un circuit de protection ESD tel que défini par la revendication 1, et son procédé de fabrication tel que défini par la revendication 6.

Ainsi, un mode de réalisation prévoit un circuit de protection ESD comprenant une borne connectée à la cathode d'une première diode et à l'anode d'une deuxième diode, la cathode de la deuxième diode n'étant pas constituée de silicium épitaxié.

Selon un mode de réalisation, le circuit comprend une deuxième borne connectée à la cathode d'une troisième diode et à l'anode d'une quatrième diode.

Selon un mode de réalisation, la cathode de la quatrième diode n'est pas constituée de silicium épitaxié.

Selon un mode de réalisation, l'anode de la première diode est connectée à l'anode d'une première diode à avalanche et l'anode de la troisième diode est connectée à l'anode d'une deuxième diode à avalanche.

Selon un mode de réalisation, les cathodes des deuxième et quatrième diodes et des première et deuxième diodes à avalanche sont connectées à un même noeud.

Selon un mode de réalisation, les cathodes des première et deuxième diodes à avalanche comprennent du silicium épitaxié dopé N.

Selon un mode de réalisation, les cathodes des deuxième et quatrième diodes sont en silicium massif.

Selon un mode de réalisation, les anodes des première, deuxième, troisième et quatrième diodes comprennent du silicium épitaxié dopé P.

Un autre mode de réalisation prévoit un procédé de fabrication d'un circuit de protection ESD comprenant une borne connectée à la cathode d'une première diode et à l'anode d'une deuxième diode, la cathode de la deuxième diode n'étant pas constituée de silicium épitaxié.

Selon un mode de réalisation, le procédé comprend une étape de gravure de cavités dans un substrat semiconducteur.

Selon un mode de réalisation, le substrat est du silicium dopé N.

Selon un mode de réalisation, le substrat est du silicium massif.

Selon un mode de réalisation, le procédé comprend une étape de formation par épitaxie de silicium dans les cavités.

Selon un mode de réalisation, le silicium épitaxié situé dans chaque cavité constitue la cathode d'une diode à avalanche.

Selon un mode de réalisation, le procédé comprend la formation d'une diode en série et d'une diode en parallèle de chaque diode à avalanche.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 illustre schématiquement un exemple de circuit de protection contre les décharges électrostatiques ; et
la figure 2 est une vue en coupe illustrant un mode de réalisation du circuit de la figure 1.

### Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, les systèmes dans lesquels peuvent être utilisés les modes de réalisation décrits ne sont pas détaillés.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence à l'orientation des éléments concernés dans les figures. Sauf précision contraire, les expressions "approximativement", "sensiblement", "environ" et "de l'ordre de" signifient à 10 % près, de préférence à 5 % près.

Sauf précision contraire, lorsque l'on fait référence à deux éléments connectés entre eux, cela signifie que ces éléments sont directement connectés sans élément intermédiaire autre que des conducteurs, et lorsque l'on fait référence à deux éléments reliés ou couplés entre eux, cela signifie que ces deux éléments peuvent être directement reliés (connectés) ou reliés par l'intermédiaire d'un ou plusieurs autres éléments.

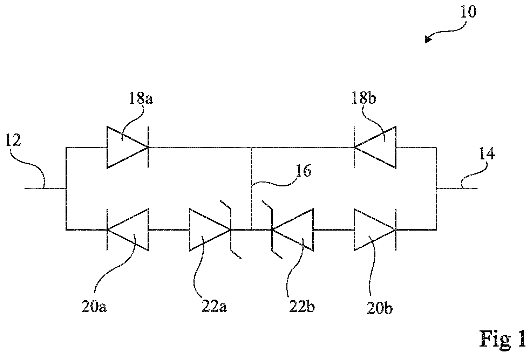

La figure 1 illustre schématiquement un exemple de circuit 10 de protection contre les décharges électrostatiques.

Le circuit 10 comprend deux bornes 12 et 14. Une des bornes 12 et 14 est par exemple reliée à la masse et l'autre à un plot de contact, non représenté, que l'on souhaite protéger. Le circuit 10 comprend de plus un noeud central de connexion 16.

Alternativement, le noeud central peut être relié à la masse et les bornes 12 et 14 peuvent être reliées à des plots de contact non représentés.

La borne 12 est reliée au noeud 16 par une diode 18a dont l'anode est connectée à la borne 12 et dont la cathode est connectée au noeud 16. De plus, la borne 12 est reliée au noeud 16 par une diode 20a en série avec une diode à avalanche 22a. Plus précisément, la cathode de la diode 20a est connectée à la borne 12 et son anode est connectée à l'anode de la diode à avalanche 22a. La cathode de la diode à avalanche 22a est connectée au noeud 16. La diode 20a et la diode à avalanche 22a sont donc en parallèle avec la diode 18a, entre la borne 12 et le noeud 16.

Similairement, la borne 14 est reliée au noeud 16 par une diode 18b dont l'anode est connectée à la borne 14 et dont la cathode est connectée au noeud 16. De plus, la borne 14 est reliée au noeud 16 par une diode 20b en série avec une diode à avalanche 22b. Plus précisément, la cathode de la diode 20b est connectée à la borne 14 et son anode est connectée à l'anode de la diode à avalanche 22b. La cathode de la diode à avalanche 22b est connectée au noeud 16. La diode 20 et la diode à avalanche 22b sont donc en parallèle avec la diode 18b, entre la borne 14 et le noeud 16. Les diodes à avalanche 22a et 22b sont par exemple des diodes Zener.

On considère par exemple que la borne 14 est reliée à la masse et que la borne 12 est reliée à un plot de contact.

Un pic positif de tension au niveau de la borne 12 rend passante la diode 18a et, si l'amplitude du pic de tension est suffisamment élevée pour provoquer le phénomène d'avalanche dans la diode 22b, la diode à avalanche 22b et la diode 20b. Le pic est donc dissipé dans la masse. Un pic négatif de tension au niveau de la masse entraîne un phénomène similaire. Le pic de tension rend passante la diode 18b et, si l'amplitude du pic de tension est suffisamment élevée pour provoquer le phénomène d'avalanche dans la diode 22a, la diode à avalanche 22a et la diode 20a. Le pic de tension est donc dissipé par la borne 12. Le circuit 10 est donc bidirectionnel.

Le choix des seuils des diodes à avalanche 22a et 22b permet de choisir à partir de quelle amplitude le pic de tension doit être dissipé.

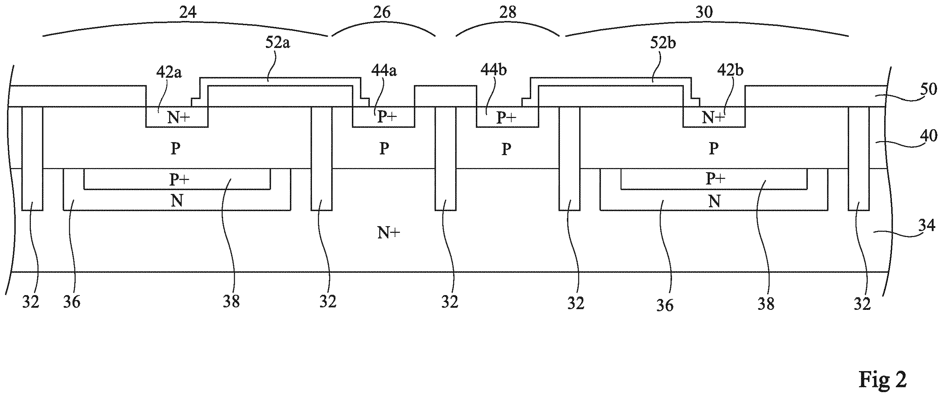

La figure 2 est une vue en coupe illustrant un mode de réalisation du circuit 10 de la figure 1

Le circuit 10 comprend, de gauche à droite en figure 2, une zone 24 où sont formées la diode à avalanche 22a (figure 1) et la diode 20a (figure 1), une zone 26 où est formée la diode 18a (figure 1), une zone 28 où est formée la diode 18b (figure 1) et une zone 30 où sont formées la diode à avalanche 22b (figure 1) et la diode 20b (figure 1).

Les différentes zones sont séparées, les unes des autres et de composants voisins, par des puits isolants 32, par exemple des puits dopés N.

Le circuit 10 comprend un substrat 34 en matériau semiconducteur, par exemple en silicium. Le substrat 34 est dopé N (N+). Le substrat 34 est par exemple en silicium massif.

Le substrat 34 contient des régions 36 en silicium épitaxié. Le silicium épitaxié des régions 36 est dopé N. Une région 38 de silicium dopé P (P+) est située dans la partie supérieure dans chaque région 36.

Les régions 36 et 38 s'étendent dans les zones 24 et 30, par exemple sur plus de 90 % de leurs largeurs. Les régions 38 sont séparées des puits 32 par des portions de substrat 34 et/ou des portions de région 36.

Les régions 36 et 38 situées dans la zone 24 constituent respectivement la cathode et l'anode de la diode à avalanche 22a. De même, les régions 36 et 38 situées dans la zone 30 constituent respectivement la cathode et l'anode de la diode à avalanche 22b.

Le circuit 10 comprend de plus une couche 40 de silicium épitaxié dopé P. La couche 40 est située sur le substrat 34 et sur les régions 36 et 38. Cette couche 40 s'étend sur le substrat, au moins dans les zones 24, 26, 28 et 30.

Les zones 24 et 30 comprennent chacune, en partie supérieure de la couche 40, une région 42 (42a en zone 24 et 42b en zone 30) de silicium dopé N (N+). Les régions 42 correspondent à la cathode de la diode 20a (zone 24) et de la diode 20b (zone 30). Les parties de la couche 40 situées dans les zones 24 et 30 constituent les anodes de la diode 20a (zone 24) et de la diode 20b (zone 30). Les contacts entre la couche 40 et les régions 38 dans les zones 24 et 30 forment les connexions électriques entre les anodes des diodes 20a et 20b et les anodes des diodes à avalanche 22a et 22b.

Dans les zones 26 et 28, les diodes 18a et 18b sont formées par le substrat dopé N et la couche 40 dopée P. Les zones 26 et 28 comprennent par exemple chacune, en partie supérieure, une région 44 (44a en zone 26 et 44b en zone 28) de silicium dopé P (P+), plus fortement dopée que la couche 40, de manière à faciliter la prise de contact. Le silicium du substrat est par exemple du silicium massif. Les cathodes des diodes 18a et 18b ne comprennent donc pas de silicium épitaxié.

Le circuit comprend de plus une couche d'isolant 50, par exemple en oxyde thermique. La couche 50 comprend des ouvertures découvrant les régions 42 et 44. Des couches 52 de matériau conducteur, par exemple un métal, s'étendent sur les côtés de portions de la couche 50 de manière à connecter électriquement chaque région 42 à une région 44. Plus précisément, la région 42a de la zone 24 est connectée à la région 44a de la zone 26 par une couche 52a et la région 42b de la zone 30 est connectée à la région 44b de la zone 28 par une couche 52b.

Ainsi, le substrat 34 constitue le noeud 16, les régions 42 et 44 des zones 24 et 26 constituent par exemple la borne 12 et les régions 42 et 44 des zones 28 et 30 constituent par exemple la borne 14.

Les valeurs de seuil d'avalanche des diodes à avalanche 22a et 22b dépendent des profondeurs et des résistivités des régions 36 des zones 24 et 30. Par exemple, les régions 36 des zones 24 et 30 ont une profondeur comprise entre environ 5 et environ 10 um, et ont une résistivité supérieure à environ 0,07 Ω.cm. Les régions 36 peuvent avoir sensiblement les mêmes dimensions. Les diodes à avalanche 22a et 22b ont alors sensiblement la même valeur de seuil d'avalanche. Les régions 36 peuvent aussi avoir des dimensions différentes, plus particulièrement une profondeur différente. Les seuils d'avalanche des diodes à avalanche 22a et 22b sont alors différents et indépendants l'un de l'autre.

On considère par exemple que la borne 12 (figure 1), constituée par les régions 42a et 44a et la couche 52a, est reliée à un plot de contact non représenté. On considère par exemple que la borne 14 (figure 1), constituée par les régions 42b et 44b et la couche 52b, est reliée à la masse. Lorsqu'un pic positif de tension survient au niveau de la borne 12, par exemple lorsqu'un utilisateur touche le plot de contact non représenté, la diode de la zone 26 (18a, figure 1, constituée par la partie de la couche 40 en zone 26 et le substrat 34) devient passante. Si l'amplitude du pic est suffisamment importante pour déclencher le phénomène d'avalanche de la diode à avalanche de la zone 30 (22b, figure 1, constituée par les régions 36 et 38 de la zone 30), cette diode à avalanche ainsi que la diode de la zone 30 (20b, figure 1, constituée par la région 42b et la couche 40 de la zone 30) deviennent passantes. Le pic de tension est ainsi dissipé dans la masse. De manière similaire, lorsqu'un pic positif de tension survient au niveau de la borne 14, la diode de la zone 28 (18b, figure 1, constituée par la partie de la couche 40 en zone 28 et le substrat 34) devient passante. Si l'amplitude du pic est suffisamment importante pour déclencher le phénomène d'avalanche de la diode à avalanche de la zone 24 (22a, figure 1, constituée par les régions 36 et 38 de la zone 24), cette diode à avalanche ainsi que la diode de la zone 24 (20a, figure 1, constituée par la région 42a et la couche 40 de la zone 24) deviennent passantes. Le pic de tension est alors dissipé par la borne 12.

Un exemple de procédé de fabrication du circuit de la figure 2 comprend une étape de formation de première et deuxième cavités aux emplacements où l'on souhaite former les régions 36. Du silicium est formé par épitaxie dans les cavités de manière à former les régions 36. Les dimensions, en particulier la profondeur, des première et deuxième cavités peuvent être sensiblement égales ou différentes. Les régions 38 sont ensuite formées dans les régions 36.

Le procédé comprend, de plus, des étapes de formation par épitaxie de la couche 40, la formation des régions 42 et 44 dans la couche 40, la formation des puits isolants 32 entre les différentes zones, la formation de la couche 50 et la formation des couches conductrices 52. Le procédé comprend aussi les étapes de dopages des différentes régions et couches.

On aurait pu choisir de ne pas former de cavité et de former par épitaxie une couche de silicium sur l'ensemble du substrat 34. Les zones 26 et 28 correspondant aux diodes 18a et 18b auraient alors compris une couche de silicium épitaxié dopé N, comme les zones 24 et 26. Cependant, cette couche de silicium épitaxié entraînerait une augmentation de la résistance dynamique des diodes 18a et 18b qui conduiraient donc moins vite et dégraderaient la qualité de la protection du circuit. De plus, il ne serait alors plus possible de choisir les seuils d'avalanche des diodes à avalanche 22a et 22b indépendamment l'un de l'autre. De plus, les diodes 18a et 18b seraient alors dégradées et seraient moins rapides.

Des modes de réalisation particuliers ont été décrits. Diverses variantes et modifications apparaîtront à l'homme de l'art. En particulier, les modes de réalisation décrits s'appliquent aussi à un circuit unidirectionnel ne comprenant qu'une diode 18a ou 18b, une diode 20a ou 20b et une diode à avalanche 22a ou 22b.

De plus, les puits isolants 32 peuvent être remplacés par des tranchées isolantes, par exemple en oxyde de silicium ou en nitrure de silicium.

En outre, les types de conductivités des différentes parties décrites peuvent être inversés.

Les régions 36 et 38 s'étendent alors sur toute la largeur des régions 24 et 30. Les régions 36 et 38 peuvent s'étendre éventuellement en dehors des tranchées isolantes 32 délimitant les zones 24 et 30. Les régions 36 et 38 peuvent éventuellement s'étendre sur une partie, par exemple moins de 30 %, des zones 26 et 28. Cela permet de ne conserver dans les zones 24 et 30 que les parties des régions 36 et 38 les plus dopées ou les moins abîmées.

A titre de variante, si l'on souhaite isoler les zones 26 et 28 des parties des régions 36 et 38 s'étendant hors des zones 24 et 30, il est possible de former des tranchées isolantes 32 entre les zones 26 et 28 et les régions 36 et 38. La zone entre les zones 24 et 26 et celle entre les zones 28 et 30 sont alors recouvertes par la couche d'isolant 50 et la couche conductrice 52.

Divers modes de réalisation avec diverses variantes ont été décrits ci-dessus. On notera que l'homme de l'art pourra combiner divers éléments de ces divers modes de réalisation et variantes sans faire preuve d'activité inventive.

## Revendications

1. Circuit intégré sur substrat semiconducteur (34) de protection ESD comprenant :
une première couche (40) formée sur le substrat dans des première (24) et troisième (30) zones de laquelle sont définies des régions d'anode de première (20a) et troisième (20b) diodes ;
en partie supérieure desdites première et troisième zones de la première couche, des régions définissant des cathodes des première (20a) et troisième (20b) diodes ;
en partie supérieure de deuxième (26) et quatrième (28) zones de la première couche, des régions (44a, 44b) définissant des anodes de deuxième (18a) et quatrième (18b) diodes ;
une première borne (12) connectée à la cathode (42a) de la première diode (20a) et à l'anode (44a) de la deuxième diode (18a), la cathode de la deuxième diode ne comprenant pas de silicium épitaxié ;
une deuxième borne (14) connectée à la cathode (42b) de la troisième diode (20b) et à l'anode (44b) de la quatrième diode (18b),
et dans lequel :
l'anode de la première diode est connectée à l'anode (38) d'une première diode (22a) à avalanche et l'anode de la troisième diode est connectée à l'anode (38) d'une deuxième diode à avalanche (22b), les cathodes (36, 34) des deuxième et quatrième diodes et des première et deuxième diodes à avalanche étant connectées à un même noeud (16) et les diodes à avalanche étant formées de régions (36, 38) dans le substrat (34).

2. Circuit selon la revendication 1, dans lequel la cathode de la quatrième diode ne comprend pas de silicium épitaxié.

3. Circuit selon la revendication 1 ou 2, dans lequel les cathodes des première et deuxième diodes à avalanche comprennent du silicium épitaxié dopé N.

4. Circuit selon l'une quelconque des revendications 1 à 3, dans lequel les cathodes des deuxième et quatrième diodes sont en silicium massif.

5. Circuit selon l'une quelconque des revendications 1 à 4, dans lequel les anodes des première, deuxième, troisième et quatrième diodes comprennent du silicium épitaxié dopé P (40).

6. Procédé de fabrication d'un circuit de protection ESD selon l'une quelconque des revendication 1 à 5, comprenant une étape de formation d'une borne (12) connectée à la cathode (42a) d'une première diode (20a) et à l'anode (44a) d'une deuxième diode (18a), la cathode de la deuxième diode ne comprenant pas de silicium épitaxié.

7. Procédé selon la revendication 6, comprenant une étape de gravure de cavités dans un substrat semiconducteur.

8. Procédé selon la revendication 7, dans lequel le substrat est du silicium dopé N.

9. Procédé selon la revendication 6 ou 7, dans lequel le substrat est du silicium massif.

10. Procédé selon l'une quelconque des revendications 7 à 9, comprenant une étape de formation par épitaxie de silicium dans les cavités.

11. Procédé selon la revendication 10, dans lequel le silicium épitaxié situé dans chaque cavité constitue la cathode d'une diode à avalanche.

12. Procédé selon la revendication 11, comprenant la formation d'une diode en série et d'une diode en parallèle de chaque diode à avalanche.

## Patentansprüche

1. Integrierte ESD-Schaltung auf einem Halbleitersubstrat, die Folgendes aufweist:
eine erste Schicht (40), die auf dem Substrat in einem ersten (24) und einem dritten (30) Gebiet ausgebildet ist, in denen die Anodenbereiche von ersten (20a) und dritten (20b) Dioden definiert sind;
in einem oberen Teil des ersten und dritten Gebiets der ersten Schicht Bereiche, die die Kathoden der ersten (20a) und dritten (20b) Dioden definieren;
in einem oberen Teil von zweiten (26) und vierten (28) Gebieten der ersten Schicht, Bereiche (44a, 44b), die die Anoden der zweiten (18a) und vierten (18b) Dioden definieren;
einen ersten Anschluss (12), der mit der Kathode (42a) der ersten Diode (20a) und mit der Anode (44a) der zweiten Diode (18a) verbunden ist, wobei die Kathode der zweiten Diode nicht aus epitaktischem Silizium hergestellt ist;
einen zweiten Anschluss (14), der mit der Kathode (42b) einer dritten Diode (20b) und mit der Anode (44b) einer vierten Diode (18b) verbunden ist,
und wobei:
die Anode der ersten Diode mit der Anode (38) einer ersten Avalanche-Diode (22a) verbunden ist und die Anode der dritten Diode mit der Anode (38) einer zweiten Avalanche-Diode (22b) verbunden ist, wobei die Kathoden (36, 34) der zweiten und vierten Dioden und der ersten und zweiten Avalanche-Dioden mit einem gleichen Knoten (16) verbunden sind und die Avalanche-Dioden aus Bereichen im Substrat (34) ausgebildet sind.

2. Schaltung nach Anspruch 1, wobei die Kathode der vierten Diode nicht aus epitaktischem Silizium hergestellt ist.

3. Schaltung nach Anspruch 1 oder 2, wobei die Kathoden der ersten und zweiten Avalanche- Dioden N-dotiertes epitaktisches Silizium aufweisen.

4. Schaltung nach einem der Ansprüche 1 bis 3, wobei die Kathoden der zweiten und der vierten Dioden aus Silizium-Bulk hergestellt sind.

5. Schaltung nach einem der Ansprüche 1 bis 4, wobei die Anoden der ersten, zweiten, dritten und vierten Dioden P-dotiertes epitaktisches Silizium (40) aufweisen.

6. Verfahren zum Herstellen einer ESD-Schutzschaltung nach einem der Ansprüche 1 bis 5, aufweisend einen Anschluss (12), der mit der Kathode (42a) einer ersten Diode (20a) und mit der Anode (44a) einer zweiten Diode (18a) verbunden ist, wobei die Kathode der zweiten Diode nicht aus epitaktischem Silizium hergestellt ist.

7. Verfahren nach Anspruch 6, aufweisend einen Schritt des Ätzens von Hohlräumen in einem Halbleitersubstrat.

8. Verfahren nach Anspruch 7, wobei das Substrat N-dotiertes Silizium ist.

9. Verfahren nach Anspruch 6 oder 7, wobei das Substrat festes Silizium ist.

10. Verfahren nach einem der Ansprüche 7 bis 9, aufweisend einen Schritt des Ausbildens von Silizium in den Hohlräumen durch Epitaxie.

11. Verfahren nach Anspruch 10, wobei das epitaktische Silizium, das sich in jedem Hohlraum befindet, die Kathode einer Avalanche-Diode bildet.

12. Verfahren nach Anspruch 11, aufweisend Ausbilden einer Diode in Reihe und einer Diode parallel zu jeder Avalanche-Diode.

## Claims

1. An ESD protection integrated circuit on semiconductor substrate comprising :
a first layer (40), formed on the substrate in first (24) and third (30) areas, of which are defined the anode regions of first (20a) and third (20b) diodes;
in an upper part of said first and third areas of the first layer, regions defining the cathodes of the first (20a) and third (20b) diodes;
in an upper part of second (26) and fourth (28) areas of the first layer, regions (44a, 44b) defining the anodes of the second (18a) and fourth (18b) diodes;
a first terminal (12) connected to the cathode (42a) of the first diode (20a) and to the anode (44a) of the second diode (18a), the cathode of the second diode not being made of epitaxial silicon;
a second terminal (14) connected to the cathode (42b) of a third diode (20b) and to the anode (44b) of a fourth diode (18b),
and wherein :
the anode of the first diode is connected to the anode (38) of a first avalanche diode (22a) and the anode of the third diode is connected to the anode (38) of a second avalanche diode (22b), the cathodes (36, 34) of the second and fourth diodes and of the first and second avalanche diodes being connected to a same node (16) and the avalanche diodes being made of regions in the substrate (34).

2. The circuit of claim 1, wherein the cathode of the fourth diode is not made of epitaxial silicon.

3. The circuit of claim 1 or 2, wherein the cathodes of the first and second avalanche diodes comprise N doped epitaxial silicon.

4. The circuit of any of claims 1 to 3, wherein the cathodes of the second and fourth diodes are made of silicon bulk.

5. The circuit of any of claims 1 to 4, wherein the anodes of the first, second, third, and fourth diodes comprise P doped epitaxial silicon (40).

6. A method of manufacturing an ESD protection circuit according to any of claims 1 to 5, comprising a terminal (12) connected to the cathode (42a) of a first diode (20a) and to the anode (44a) of a second diode (18a), where the cathode of the second diode is not made of epitaxial silicon.

7. The method of claim 6, comprising a step of etching cavities in a semiconductor substrate.

8. The method of claim 7, wherein the substrate is N doped silicon.

9. The method of claim 6 or 7, wherein the substrate is solid silicon.

10. The method of any of claims 7 to 9, comprising a step of forming by epitaxy silicon in the cavities.

11. The method of claim 10, wherein the epitaxial silicon located in each cavity forms the cathode of an avalanche diode.

12. The method of claim 11, comprising forming a diode in series and a diode in parallel with each avalanche diode.
